# EUROPÄISCHE PATENTANMELDUNG

(11) **EP 4 531 084 A1**
(43) Veröffentlichungstag der Anmeldung: **02.04.2025**
(21) Anmeldenummer: 23201001.7
(22) Anmeldetag: 29.09.2023
(51) Int. Cl.: H01L 21/687

(54) **TRÄGERBAUGRUPPE UND SYSTEM**

(71) Anmelder: Bühler Alzenau GmbH, 63755 Alzenau (DE)
(72) Erfinder: PAUFLER, André, 63755 Alzenau (DE)
(74) Vertreter: Prinz & Partner mbB

(57) **Zusammenfassung**

Die Erfindung betrifft eine Trägerbaugruppe (24) zum spielfreien Positionieren eines Wafers (22), mit einem Träger (26) für den Wafer (22), einem Kippmechanismus (40) und einem Positionierteil (34). Der Träger (26) hat eine Öffnung (30) zur Aufnahme des Wafers (22). Das Positionierteil (34) hat eine Positionierfläche (36) zum seitlichen Positionieren des Wafers (22). Der Kippmechanismus (40) ist eingerichtet, das Positionierteil (34) zwischen einer Freigabestellung und einer Positionierstellung zu verkippen, in der der Wafer (22) zwischen einem Rand der Öffnung (30) und der Positionierfläche (36) positioniert ist. Ferner betrifft die Erfindung ein System (10) sowie ein Verfahren zum spielfreien Positionieren eines Wafers bzw. zum Entnehmen eines Wafers aus einem Träger.

## Beschreibung

Die Erfindung betrifft eine Trägerbaugruppe zum spielfreien Positionieren eines Wafers. Ferner betrifft die Erfindung ein System sowie ein Verfahren zum spielfreien Positionieren eines Wafers in einem Träger für den Wafer und ein Verfahren zum Entnehmen eines Wafers aus einem Träger für den Wafer.

Aus dem Stand der Technik ist es bekannt, dass Wafer zur Verarbeitung, beispielsweise lonenbestrahlung und/oder Vermessen, in einem Träger positioniert werden, sodass die Wafer in einer möglichst definierten Position gehalten sind. Dies ist insbesondere bei automatisierten Systemen bzw. Prozessstraßen von Bedeutung, bei denen der Wafer mehrere Stationen nacheinander durchläuft, beispielsweise eine erste Messstation, eine Bestrahlungsstation und eine zweite Messstation.

Bei den aus dem Stand der Technik bekannten Trägerbaugruppen hat sich herausgestellt, dass die Prozessierbarkeit der Wafers eingeschränkt ist, da die aus dem Stand der Technik bekannten Trägerbaugruppen den Wafer entweder teilweise verdecken, sodass der Wafer nur einseitig prozessiert werden kann, oder Teile des Außenrands des Wafers verdeckt sind, wodurch die Oberfläche, welche zur Bearbeitung zur Verfügung steht, gegenüber der gesamten Oberfläche des Wafers eingeschränkt ist.

Zudem benötigen die aus dem Stand der Technik bekannten Trägerbaugruppen typischerweise eine manuelle Entriegelung, wodurch der Einsatz in einer vollautomatisierten Prozessstraße nur bedingt möglich ist.

Darüber hinaus wird bei den aus dem Stand der Technik bekannten Trägerbaugruppen der Wafer innerhalb des Träger mittels komplexer Mechanismen gehalten bzw. geklemmt, die einen entsprechenden Platzbedarf haben. Hierdurch ist die Effizienz einer vollautomatisierten Verarbeitung verringert, da die Anzahl der Wafer begrenzt ist, die gleichzeitig verarbeitet werden können.

Die Aufgabe der Erfindung ist es, eine Trägerbaugruppe zur Verfügung zu stellen, mit der eine vollautomatisierte Verarbeitung des Wafers möglich ist und gleichzeitig die Effizienz der Verarbeitung maximiert ist.

Die Aufgabe wird erfindungsgemäß gelöst durch eine Trägerbaugruppe zum spielfreien Positionieren eines Wafers. Die Trägerbaugruppe weist einen Träger für den Wafer, einen Kippmechanismus und ein Positionierteil auf. Der Träger hat eine Öffnung zur Aufnahme des Wafers. Das Positionierteil hat eine Positionierfläche zum seitlichen Positionieren des Wafers. Der Kippmechanismus ist eingerichtet, das Positionierteil zwischen einer Freigabestellung und einer Positionierstellung zu verkippen, in der der Wafer zwischen einem Rand der Öffnung und der Positionierfläche positioniert ist.

Der Grundgedanke der Erfindung ist es, eine Positionierung des Wafers wiederholgenau mittels der Trägerbaugruppe zu ermöglichen, indem der Wafer durch die Positionierfläche des Positionierteils in dem Träger positioniert wird. Hierdurch wird die Position des Wafers innerhalb des Trägers (exakt) festgelegt, wodurch die Wiederholbarkeit der Positionierung gewährleistet ist. Mit anderen Worten ist sichergestellt, dass alle in der Trägerbaugruppe eingesetzten Wafer in gleicher Weise positioniert sind. Zudem stellt das Positionierteil sicher, dass der Wafer in seiner festgelegten Position verbleibt, auch wenn die Trägerbaugruppe (leichten) Erschütterungen unterliegt, die beispielsweise in einer Prozessstraße auftreten können, also in einem (voll-)automatisierten System. Insofern kann der Wafer spielfrei während der Vermessung, des Transports und der Bearbeitung in einer Vakuumkammer positioniert sein.

Da das Positionierteil zwischen seiner Freigabestellung und seiner Positionierteil über dem Kippmechanismus verstellt wird, ist zudem eine platzsparende sowie einfache Möglichkeit geschaffen, den Wafer hinsichtlich seiner Position im Träger festzulegen. Über den Kippmechanismus ist sichergestellt, dass sich die Trägerbaugruppe für eine vollautomatisierte Verarbeitung eignet, da der Kippmechanismus sowohl manuell als auch automatisch betätigt werden kann, beispielsweise über ein Auslöseelement, welches mit dem Kippmechanismus zusammenwirkt.

Des Weiteren ist mittels des Kippmechanismus sichergestellt, dass die Trägerbaugruppe auch für (Ultra-)Hochvakuum-Anwendungen geeignet ist, bei denen andersartige Positioniermechanismen versagen würden, beispielsweise Positioniermechanismen, bei denen Gleitelemente aneinander gleiten. Im Gegensatz hierzu umfasst der Kippmechanismus nämlich ein Schwenken oder Kippen um eine Achse, also eine schwenk- bzw. kippbare Lagerung. Eine derartige Lagerung weist eine deutlich geringere Reibung im Vergleich zu einer Gleitlagerung auf.

Da das Positionierteil mittels der Positionierfläche den Wafer seitlich positioniert, ist zudem gewährleistet, dass die zu prozessierende Oberfläche des Wafers nicht (teilweise) durch das Positionierteil verdeckt ist, wie dies beispielsweise bei einem Niederhalter der Fall wäre, der eine Oberfläche des Wafers kontaktiert, um den Wafer niederzuhalten.

Aufgrund des Kippmechanismus lassen sich eine platzsparende und dennoch spielfreie Positionierung des Wafers im Träger, eine maximale Verarbeitungsmöglichkeit der Oberfläche(n) des Wafers sowie die Automatisierungsmöglichkeit der Beladung des Trägers mit dem Wafer und der Entnahme des Wafers aus dem Träger realisieren.

Ein Aspekt sieht vor, dass der Kippmechanismus wenigstens eine Betätigungsfläche aufweist, über die der Kippmechanismus betätigbar ist, um das Positionierteil zwischen der Positionierstellung und der Freigabestellung zu verkippen. Die Betätigungsfläche ist in der Positionierstellung des Positionierteils senkrecht zur Positionierfläche. Insofern ist über den Kippmechanismus sichergestellt, dass sich die Kraftwirkungsrichtung um 90° ändert, da der Kippmechanismus von oben oder unten ausgelöst wird, indem die Betätigungsfläche betätigt wird, was eine seitliche Kraft auf den Wafer zur Folge hat, die über die Positionierfläche des Positionierteils auf den Wafer aufgebracht wird. Durch das Verkippen des Positionierteils mittels des Kippmechanismus wird die Richtungsumkehr realisiert.

Die Betätigungsrichtung des Kippmechanismus, also die Richtung über die der Kippmechanismus ausgelöst wird, ist demnach parallel zur Belade- und Entnahmerichtung des Wafers.

Der Kippmechanismus kann ein Betätigungsteil aufweisen, das mit dem Positionierteil mechanisch verbunden ist, wobei die Betätigungsfläche am Betätigungsteil ausgebildet ist. Insofern sind mindestens zwei separat ausgebildete Teile vorhanden, die unterschiedlichen Anforderungen genügen. Das Positionierteil, welches über seine Positionierfläche mit dem Wafer in direktem Kontakt steht, kann aus einem anderen Material gebildet sein als das Betätigungsteil, welches mit dem Wafer nicht in direktem Kontakt steht. Insofern lässt sich eine kostengünstigere Trägerbaugruppe realisieren.

Insbesondere ist das Positionierteil aus einem lonenstrahl-resistenten Material gebildet, beispielsweise Grafit oder PTFE. Dies gilt in analoger Weise für den Träger. Mit anderen Worten sind die Komponenten aus dem lonenstrahl-resistenten Material gebildet, die den Wafer kontaktieren. Ein derartiges Material eignet sich zudem für (Ultra-)Hochvakuum-Anwendungen.

Demgegenüber kann das Betätigungsteil aus einem Metall gefertigt sein, beispielsweise Aluminium, sodass es möglichst leicht und dennoch stabil ist, wodurch das Gesamtgewicht der Trägerbaugruppe reduziert.

Auch kann das Positionierteil selbst die Betätigungsfläche aufweisen, sodass keine zwei separaten Teile vorgesehen sind, sondern ein einstückig ausgebildetes Bauteil, welches die Funktionen des Positionierteils und des Betätigungsteils gleichzeitig übernimmt. Insofern wäre dieses einstückige Bauteil zum seitlichen Positionieren des Wafers als auch zur Betätigung des Kippmechanismus vorgesehen.

Ein weiterer Aspekt sieht vor, dass der Kippmechanismus wenigstens einen Lagerbock aufweist, der einen Schwenkpunkt für das Betätigungsteil definiert. Der Lagerbock kann aus einem PTFE-Material ausgebildet sein, sodass es für (Ultra-)Hochvakuum-Anwendungen geeignet ist. In dem Lagerbock kann ein Passstift angeordnet sein, welcher eine Schwenkachse des Kippmechanismus definiert. Insofern ist der Schwenkpunkt für das Betätigungsteil über den Lagerbock bzw. den im Lagerbock eingesetzten Passstift vorgegeben.

Ein weiterer Aspekt sieht vor, dass der Träger eine randseitige Aussparung aufweist, durch die sich der Kippmechanismus teilweise erstreckt. Hierdurch ergibt sich eine kompakte Ausführung der Trägerbaugruppe, da der Träger aufgrund der randseitigen Aussparung auf eine minimale Materialstärke reduziert ist. Der Kippmechanismus verläuft teilweise parallel zur Belade- bzw. Entnahmerichtung durch die randseitige Aussparung. Mit anderen Worten ist aufgrund der randseitigen Aussparung sichergestellt, dass der Kippmechanismus nicht über einen Rand des Trägers seitlich hinaussteht. Dies gewährleistet unter anderem, dass mehrere Trägerbaugruppen auf einem Mehrfachträger nebeneinander platziert werden können, wodurch die Anzahl der Trägerbaugruppen pro Mehrfachträger maximiert werden kann. Dies wiederum erhöht die Effizienz bei der Verarbeitung, da gleichzeitig mehrere Wafer verarbeitet werden können.

Darüber hinaus kann der Kippmechanismus in Draufsicht auf die Öffnung derart seitlich beabstandet zur Öffnung vorgesehen sein, dass ein im Träger aufgenommener Wafer von zwei entgegengesetzten Seiten zugänglich ist. Die beiden Seiten entsprechen der Ober- und Unterseite des Wafers, sodass die für die Verarbeitung vorgesehenen Oberflächen des Wafers beide zugänglich sind, insbesondere vollständig zugänglich sind. Unter "vollständig zugänglich" ist hier gemeint, dass maximal ein Rand von 1 bis 2 mm einer Oberfläche des Wafers verdeckt ist, also ein entsprechender Rand der Unterseite oder der Oberseite. Anders als im Stand der Technik sind somit beide Seiten des Trägers (vollständig) zugänglich, wodurch die eine Seite prozessiert werden kann, beispielsweise einer Ionenstrahlung ausgesetzt ist, während gleichzeitig eine Kühlung auf der entgegengesetzten Seite erfolgt. Beispielsweise wird die Unterseite des Wafers mit Ionen bestrahlt, wohingegen die Oberseite des Wafers gekühlt wird. Eine Kühlvorrichtung kann hierzu an die zu kühlende Seite angenähert werden. Eine komplizierte Kühlung, wie dies im Stand der Technik der Fall ist, kann also entfallen.

Ferner kann eine Feder vorgesehen sein, die derart mit dem Kippmechanismus zusammenwirkt, dass das Positionierteil in der Positionierstellung vorgespannt ist. Sofern keine Betätigung des Kippmechanismus erfolgt, befindet sich das Positionierteil also in der Positionierstellung, in der ein eingesetzter Wafer hinsichtlich seiner Position festgelegt sein würde. Sofern kein Wafer im Träger vorhanden ist, ist ein Beladen nur dann möglich, wenn der Kippmechanismus betätigt wird. Mit anderen Worten kann ein Einsetzen des Wafers bzw. ein Beladen des Trägers unterbunden werden, sofern nicht gleichzeitig der Kippmechanismus betätigt wird, um das Positionierteil aus der Positionierstellung in die Freigabestellung zu überführen. Die Feder kann sich am Träger abstützen, insbesondere zwischen dem Träger und dem Betätigungsteil angeordnet sein.

Gemäß einer Ausführungsvariante ist das Positionierteil ein Klemmteil, das eine Klemmfläche zum seitlichen Klemmen des Wafers hat, wobei der Kippmechanismus eingerichtet ist, das Klemmteil zwischen der Freigabestellung und einer Klemmstellung zu verkippen, in der der Wafer zwischen einem Rand der Öffnung und der Klemmfläche geklemmt ist. Insbesondere ist an einer Innenseite des Trägers eine Klemmkontur ausgebildet, die der Klemmfläche gegenüberliegt. Mittels der Klemmkontur und der Klemmfläche kann eine DreiPunkt-Kontaktierung ausgebildet werden, über die der Wafer im Träger positionsgetreu geklemmt ist. Die Position des Wafers kann entsprechend über eine Klemmung festgelegt werden.

Grundsätzlich kann die Positionier- bzw. Klemmfläche an die Kontur des Wafers angepasst sein, sodass sich eine flächige Anlage im Bereich der Positionier- bzw. Klemmfläche ergibt. Mit anderen Worten können Positionier- bzw. Klemmfläche teilkreisförmig ausgebildet sein, sofern das Positionier- bzw. Klemmteil im Bereich eines kreisförmigen Abschnitts des Wafers zur seitlichen Anlage kommt.

Alternativ kann vorgesehen sein, dass das Positionier- bzw. Klemmteil im Bereich einer Notch oder einer Flat des Wafers verwendet wird, wodurch die Positionier- bzw. Klemmfläche einer an die Notch bzw. Flat angepasste Form hat. Sofern das Positionier- bzw. Klemmteil im Bereich einer Notch bzw. Flat zum Einsatz kommt, kann gleichzeitig eine Verdrehsicherung sichergestellt werden, da der Wafer nur in einer bestimmten Lage in den Träger eingesetzt werden kann.

Sofern das Positionier- bzw. Klemmteil nicht im Bereich der Notch bzw. Flat vorgesehen ist, ist eine genaue Winkel-Ausrichtung des Wafers beim Einsetzen in die Trägerbaugruppe unbeachtlich. Der entsprechende Prozess kann sich hierdurch vereinfachen.

Ein weiterer Aspekt sieht vor, dass am Rand der Öffnung zumindest eine Auflage für einen Rand des Wafers vorgesehen ist. Insbesondere ist die zumindest eine Auflage in einem Bereich unterbrochen, in dem das Positionierteil angeordnet ist. Die Auflage kann vollständig am Rand der Öffnung vorgesehen sein, bis auf die Unterbrechung im Bereich des Positionierteils. Die zumindest eine Auflage entspricht somit einem nach innen ragenden Kragen, auf dem der Rand des Wafers aufgelegt werden kann. Es kann auch vorgesehen sein, dass mehrere Auflagen vorgesehen sind, die sich über Segmente des Rands der Öffnung erstrecken, beispielsweise drei Segmente oder vier Segmente. In jedem Fall ist sichergestellt, dass kein Segment im Bereich des Positionierteils vorgesehen ist, welches über seine Positionierfläche den Rand des Wafers seitlich kontaktiert, um die Position des Wafers im Träger festzulegen. Die Auflage kann eine Länge

Die Länge der wenigstens einen Auflage beträgt maximal 2 mm. Mit anderen Worten ragt die Auflage maximal bis zu 2 mm in Richtung der Mitte der Öffnung hinein. Insbesondere ist die Länge 1 mm. Insofern ergibt sich maximal eine Abdeckung des Rands des Wafers von bis zu 2 mm, nämlich der Länge der Auflage. Wenn mehrere segmentierte Auflagen vorgesehen sind, kann sich die insgesamt abgedeckte Fläche noch entsprechend reduzieren.

Ferner kann ein Adapterring vorgesehen sein, in dem der Träger eingesetzt ist. Der Adapterring kann aus einem anderen Material als der Träger ausgebildet sein, beispielsweise aus einem Metall wie Aluminium. Hierdurch ist sichergestellt, dass ein stabileres bzw. für das Handling besser geeignetes Material die Außenseite der Trägerbaugruppe darstellt. Darüber hinaus kann der Adapterring aus einem günstigeren Material als der Träger hergestellt werden, wodurch sich die Gesamtkosten reduzieren lassen. Die andere Materialauswahl ist insbesondere dadurch möglich, dass der Adapterring selbst nicht mit dem Wafer in Kontakt kommt, wodurch der Adapterring geringeren Anforderungen genügen muss als der Träger, welcher beim Verarbeiten des Wafers auch entsprechenden Bedingungen ausgesetzt ist.

Ferner schafft die Erfindung ein System mit einer Greifeinheit und einer Trägerbaugruppe der zuvor genannten Art. Die Greifeinheit ist vorgesehen, um die Trägerbaugruppe mit dem Wafer zu beladen bzw. den Wafer aus der Trägerbaugruppe zu entnehmen. Bei der Greifeinheit kann es sich um eine manuelle Greifeinheit handeln, beispielsweise eine Vakuumpinzette. In diesem Fall kann der Kippmechanismus manuell ausgelöst werden, beispielsweise von einem Bediener, der die Betätigungsfläche drückt. Mit der anderen Hand kann der Bediener die Vakuumpinzette halten, also die manuell bedienbare Greifeinheit, um den Wafer in den Träger der Trägerbaugruppe einzusetzen bzw. den Wafer aus der Trägerbaugruppe zu entnehmen.

Alternativ kann es sich bei der Greifeinheit um eine automatisierte Greifeinheit handeln, beispielsweise in Form eines Endeffektors eines Roboters. In dem Fall kann vorgesehen sein, dass ein automatisches Auslösen des Kippmechanismus erfolgt, wenn die automatisierte Greifeinheit den Wafer in die Trägerbaugruppe einsetzt bzw. aus der Trägerbaugruppe entnimmt.

Beispielsweise handelt es sich bei der Greifeinheit um einen Unterdruck-Greifer, der den Wafer mittels Unterdruck beim Hantieren in Position in Bezug auf die Greifeinheit hält, einen Bernoulli-Greifer, auch als Strömungsgreifer bezeichnet, oder einen elektrostatischen Greifer. Andersartige Greifer, die ebenfalls geeignet sind, können selbstverständlich auch verwendet werden.

Ein Aspekt sieht vor, dass die Greifeinheit ein Auslöseelement aufweist, das eingerichtet ist, den Kippmechanismus zu betätigen, wobei die Greifeinheit zumindest entlang einer Belade- und Entnahmerichtung beweglich ist. Die Belade- und Entnahmerichtung ist parallel zu einer Betätigungsrichtung des Kippmechanismus der Trägerbaugruppe. Das Auslöseelement betätigt beim Beladen des Trägers mit dem Wafer und beim Entnehmen des Wafers aus dem Träger den Kippmechanismus, um das Positionierteil in die Freigabestellung zu verkippen. Hierdurch ergibt sich das automatisierte Auslösen des Kippmechanismus, da die Greifeinheit das Auslöseelement aufweist, welches automatisch den Kippmechanismus betätigt, wenn die Greifeinheit in Bezug auf die Trägerbaugruppe bewegt wird, nämlich entlang der Belade- bzw. Entnahmerichtung verfahren wird, sodass das Auslöseelement mit dem Kippmechanismus in Kontakt kommt, insbesondere der Betätigungsfläche.

Das Auslöseelement kann stiftförmig ausgebildet und seitlich benachbart zu einer Saugvorrichtung der Greifeinheit ausgebildet sein, über die der Wafer gehalten wird. Beim Absetzen des Wafers entlang der Beladerichtung betätigt das Auslöseelement ab einem bestimmten Abstand zum Träger den Kippmechanismus, wodurch das Positionierteil in die Freigabestellung verkippt wird, sodass die Greifeinheit den Träger einsetzen kann. Der an der Saugvorrichtung anliegende Unterdruck wird entfernt, sodass der Wafer losgelassen wird. Anschließend wird die Greifeinheit in ihre Ausgangsstellung verfahren, wodurch das Auslöseelement den Kippmechanismus wieder freigibt, sodass dieser aufgrund der Federvorspannung zurückgestellt wird. Dies hat zur Folge, dass das Positionierteil in die Positionierstellung übergeht, in der das Positionierteil den Wafer seitlich positioniert, also die Position des Wafers innerhalb des Trägers spielfrei festlegt.

In analoger Weise erfolgt die Betätigung des Kippmechanismus beim Entnehmen des Wafers aus dem Träger mittels der Greifeinheit, da die Greifeinheit entlang der Entnahmerichtung verfahren wird, um den Wafer zu kontaktieren, wobei zuvor das Auslöseelement den Kippmechanismus betätigt hat, sodass das Positionierteil in die Freigabestellung verkippt wird, was zur Folge hat, dass die Greifeinheit den Wafer aus dem Träger nehmen kann. Dann kann die Greifeinheit über die Saugvorrichtung den Wafer kontaktieren und mittels Unterdruck halten, um den Wafer zu entnehmen.

Insbesondere ist das Auslöseelement federnd ausgebildet, wodurch sich ein zusätzlicher Hub für die Greifeinheit ergibt. Es ist sichergestellt, dass das Auslöseelement zunächst den Kippmechanismus betätigt, bevor die Greifeinheit beim Entnehmen den Wafer überhaupt kontaktiert, insbesondere die Saugvorrichtung der Greifeinheit. Die Greifeinheit wird also nach dem Auslösen des Kippmechanismus mittels des Auslöseelements weiter in Richtung des Wafers bewegt, sodass das Auslöseelement einfedert. Dies gewährleistet den zusätzlichen Hubweg für die Greifeinheit. In analoger Weise erfolgt dies beim Beladen, da auch hier das Auslöseelement einfedert und somit einen zusätzlichen Hubweg für die Greifeinheit sicherstellt, sodass die Greifeinheit, insbesondere deren Saugvorrichtung, weiter in die Beladerichtung verfahren werden kann, um den Wafer auf die wenigstens eine Auflage abzulegen. Über den Federweg des Auslöseelements kann eingestellt werden, dass die Greifeinheit den Wafer beim Entnehmen bzw. Einsetzen nicht beschädigt, da beispielsweise eine progressive Federkennlinie vorgesehen ist, wodurch verhindert wird, dass die Greifeinheit zu weit in die Beladerichtung verfahren wird. Dies stellt also eine zusätzliche Sicherheit dar, sofern die Greifeinheit vom Roboter zu weit verfahren werden würde.

Ferner weist das Auslöseelement eine größere Federstärke als der Kippmechanismus auf, sodass sichergestellt ist, dass beim Kontaktieren des Auslöseelements zunächst der Kippmechanismus betätigt wird, also die Feder des Kippmechanismus komprimiert wird, um das Positionierteil in die Freigabestellung zu verkippen, bevor das Auslöseelement einfedert bzw. eine dem Auslöseelement zugeordnete Feder komprimiert wird.

Ferner betrifft die Erfindung ein Verfahren zum spielfreien Positionieren eines Wafers in einem Träger für den Wafer. Das Verfahren weist die Schritte auf:
- Bereitstellen einer Trägerbaugruppe mit dem Träger für den Wafer,
- Betätigen eines Kippmechanismus der Trägerbaugruppe, um ein Positionierteil mit einer Positionierfläche zum seitlichen Positionieren des Wafers im Träger aus einer Positionierstellung in eine Freigabestellung zu verkippen,
- Einbringen des Wafers in den Träger, und
- Freigeben des Kippmechanismus der Trägerbaugruppe, sodass sich das Positionierteil aus der Freigabestellung in die Positionierstellung zurückstellt und die Positionierfläche seitlich am Wafer anliegt, um diesen im Träger zu positionieren.

Ferner betrifft die Erfindung ein Verfahren zum Entnehmen eines Wafers aus einem Träger für den Wafer. Das Verfahren weist die Schritte auf:
- Bereitstellen einer Trägerbaugruppe mit dem Träger für den Wafer, wobei der Wafer in dem Träger positioniert ist,
- Betätigen eines Kippmechanismus der Trägerbaugruppe, um ein Positionierteil mit einer Positionierfläche zum seitlichen Positionieren des Wafers im Träger aus einer Positionierstellung, in der die Positionierfläche seitlich am Wafer anliegt, in eine Freigabestellung zu verkippen,
- Entnehmen des Wafers aus dem Träger, und
- Freigeben des Kippmechanismus der Trägerbaugruppe, sodass sich das Positionierteil aus der Freigabestellung in die Positionierstellung zurückstellt.

Bei beiden Verfahren kann vorgesehen sein, dass der Kippmechanismus über das Auslöseelement betätigt wird, welches Teil der Greifeinheit ist, sofern ein automatisierter Prozess vorgesehen ist, der eine automatisierte Greifeinheit vorsieht. Sofern ein manuelles Beladen oder Entnehmen vorgesehen ist, kann der Kippmechanismus auch mittels einer Hand des Bedieners manuell betätigt werden, wodurch das Positionierteil in die Freigabestellung verkippt wird.

In beiden Fällen ist sichergestellt, dass die Position des Wafers im Träger durch eine seitliche Positionierung mittels des Positionierteils, insbesondere dessen Positionierfläche, gewährleistet ist, da der Kippmechanismus eine seitliche Festlegung des Wafers im Träger vorsieht. Die Betätigung des Kippmechanismus erfolgt jedoch in einer hierzu senkrechten Richtung. Typischerweise ist vorgesehen, dass die Trägerbaugruppe von oben beladen wird, sodass der Wafer von oben in die Trägerbaugruppe eingesetzt wird. In diesem Fall ist unter anderem auch vorgesehen, dass am Rand der Öffnung des Trägers zumindest eine Auflage für den Wafer vorgesehen ist, auf die der Wafer beim Einsetzen gesetzt werden kann. Die exakte Positionierung des Wafers innerhalb des Trägers erfolgt dann mittels des Positionierteils, welches den Wafer in der von der wenigstens einen Auflage aufgespannten Auflageebene seitlich so positioniert, dass seine Position spielfrei ist. Hierdurch wird die Position des Wafers im Träger entsprechend festgelegt.

Wie vorstehend bereits erläutert, ist das Positionierteil insbesondere als Klemmteil ausgebildet, sodass eine Klemmung des Wafers erfolgt.

Der Kippmechanismus stellt zudem sicher, dass beide Seiten des Wafers, also die Unterseite und die Oberseite, während der Verarbeitung vollständig zugänglich sind. Hierdurch kann die Unterseite des Wafers behandelt werden, beispielsweise mit Ionen bestrahlt werden wobei gleichzeitig eine Kühlung des Wafers über die Oberseite erfolgt.

Ferner kann die Betätigungsfläche, insbesondere das gesamte Betätigungsteil, in Draufsicht auf die Trägerbaugruppe oberhalb des Trägers und/oder des Adapterrings angeordnet sein. Mit anderen Worten ist die Öffnung nicht durch das Betätigungsteil verdeckt. Auch steht das Betätigungsteil nicht seitlich über. Hierdurch ergibt sich eine kompakte Bauweise der gesamten Trägerbaugruppe.

Der Wafer kann ein beschichtetes oder unbeschichtetes Halbleiter-Substrat, Glas und/oder Keramik aufweisen, also auch Mischungen der genannten Materialien.

Weitere Vorteile und Eigenschaften der Erfindung ergeben sich aus der nachfolgenden Beschreibung und den Zeichnungen, auf die Bezug genommen wird. In den Zeichnungen zeigen:
- Figur 1 eine schematische Darstellung eines erfindungsgemäßen Systems,
- Figur 2 eine Perspektivansicht einer erfindungsgemäßen Trägerbaugruppe,
- Figur 3 eine Explosionsansicht der erfindungsgemäßen Trägerbaugruppe aus Figur 2,
- Figur 4 eine Seitenansicht der erfindungsgemäßen Trägerbaugruppe aus Figur 2,
- Figur 5 eine Draufsicht auf die erfindungsgemäße Trägerbaugruppe aus Figur 2,
- Figur 6 eine Schnittansicht entlang der Linie A-A der Figur 5,
- Figur 7 eine vergrößerte Darstellung der Schnittansicht aus Figur 6,
- Figur 8 die Schnittansicht aus Figur 7 für eine alternative Ausführungsform der erfindungsgemäßen Trägerbaugruppe,
- Figur 9 eine Darstellung des erfindungsgemäßen Systems beim Beladen der erfindungsgemäßen Trägerbaugruppe zu einem ersten Zeitpunkt, und
- Figur 10 das erfindungsgemäße System aus Figur 9 beim Beladen der erfindungsgemäßen Trägerbaugruppe zu einem zweiten Zeitpunkt.

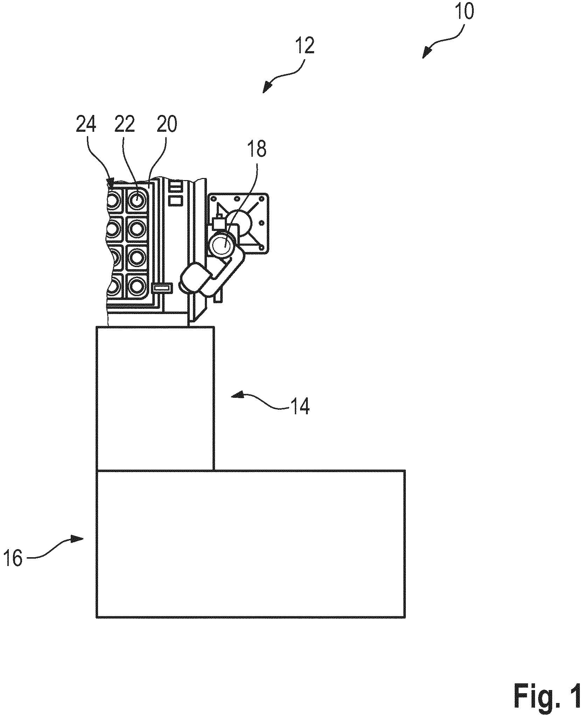

In Figur 1 ist ein System 10 gezeigt, das eingerichtet ist, mehrere Wafer gleichzeitig zu verarbeiten, beispielsweise zu bestrahlen.

Das System 10 umfasst eine Beladestation 12, eine daran anschließende Bestrahlungsstation 14 sowie eine Messstation 16. An die Messstation 16 kann sich eine Entnahmestation anschließen, die im Wesentlichen derjenigen der Beladestation 12 entspricht. Ferner kann das System 10 auch weitere Messstationen umfassen.

In der Beladestation 12 ist ein Roboter 18 vorgesehen, der einen Mehrfachträger 20 mit mehreren Wafern 22 belädt, die in Trägerbaugruppen 24 eingesetzt werden, wie nachfolgend noch detailliert erläutert wird.

Der Mehrfachträger 20 kann also mehrere Trägerbaugruppen 24 umfassen, beispielsweise acht Trägerbaugruppen 24, sodass mehrere Wafer 22 gleichzeitig in der Bestrahlungsstation 14 bestrahlt werden können. Je mehr Trägerbaugruppen 24 der einzelne Mehrfachträger 20 umfasst, desto größer ist die Gesamteffizienz, da mehr Wafer 22 gleichzeitig behandelt werden können.

Das System 10 stellt demnach eine Prozessstraße dar, mit der sichergestellt wird, dass die Wafer 22 in gewünschter Weise verarbeitet werden können. Dies wird dadurch ermöglicht, dass die Trägerbaugruppe 24 den entsprechenden Wafer 22 während der Prozessstraße positionsgetreu hält. Es ist also nicht notwendig, dass der Wafer 22 aus der Trägerbaugruppe 24 entnommen und andersartig positioniert wird.

Zudem wird mittels der Trägerbaugruppe 24 eine Wiederholgenauigkeit gewährleistet, da der Wafer 22 in der Trägerbaugruppe 24 spielfrei positioniert ist. Die spielfreie Positionierung ermöglicht es nämlich, dass beim Transport des Wafers 22 durch die mehreren Stationen des Systems 10 keine Verschiebung bzw. Positionsverlagerung des Wafers 22 erfolgt, was einen negativen Einfluss auf dessen Verarbeitung hätte.

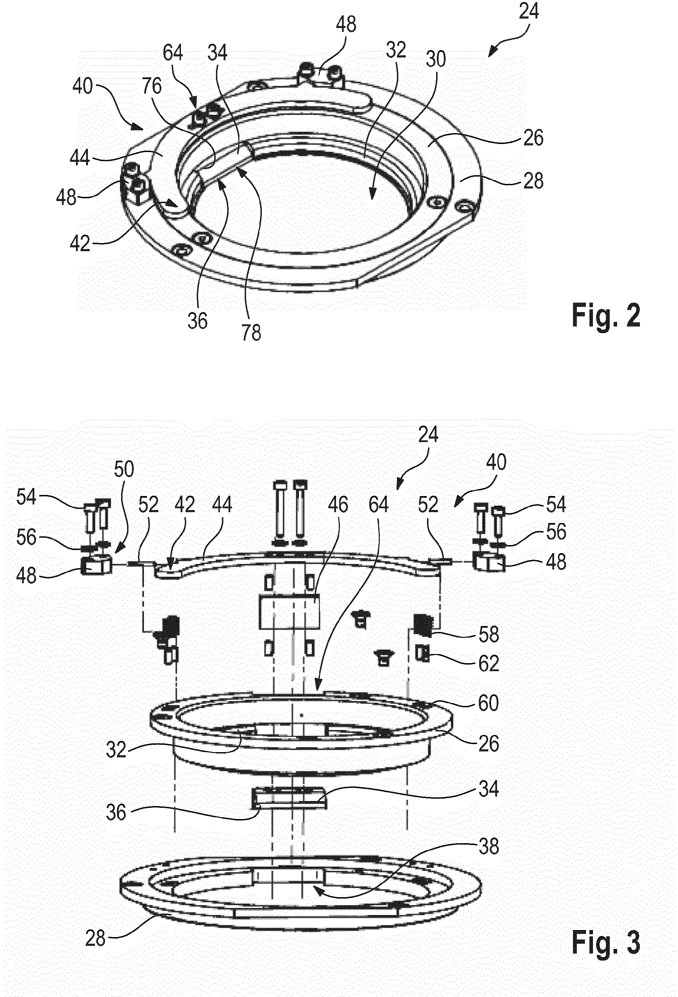

Wie vorstehend erläutert, wird dies durch die Trägerbaugruppe 24 sichergestellt, die in den Figuren 2 bis 7 gemäß einer ersten Ausführungsform detailliert gezeigt ist, worauf nachfolgend Bezug genommen wird.

Die Trägerbaugruppe 24 umfasst einen Träger 26, der als Einsatz in einem Adapterring 28 aufgenommen ist. Der Adapterring 28 kann hierzu eine Auflagefläche 29 aufweisen, an der der Träger 26 aufliegt.

Der Träger 26 hat eine Öffnung 30, über die der Wafer 22 in den Träger 26 eingesetzt werden kann. Am Rand der Öffnung 30 weist der Träger 26 zudem wenigstens eine Auflage 32 auf, auf die der Wafer 22 mit einem Rand der Unterseite aufgelegt werden kann, wenn der Wafer 22 in den Träger 26 eingesetzt wird. Bei der zumindest einen Auflage 32 handelt es sich demnach um einen nach innen ragenden Vorsprung bzw. Kragen, auf dem der Wafer 22 gesetzt werden kann. Die Auflage 32 kann bis zu 2 Millimeter hineinragen.

Darüber hinaus umfasst die Trägerbaugruppe 24 ein Positionierteil 34, das eine Positionierfläche 36 aufweist, die zum seitlichen Positionieren des Wafers 22 im Träger 26 vorgesehen ist.

Das Positionierteil 34 ist in einer nach innen weisenden Ausnehmung 38 des Trägers 26 angeordnet, wie unter anderem aus den Figuren 3, 5 und 7 hervorgeht.

Das Positionierteil 34 ist mit einem Kippmechanismus 40 betätigbar, wodurch das Positionierteil 34 zwischen einer Freigabestellung und einer Positionierstellung verkippt werden kann, in der der Wafer 22 zwischen einem Rand der Öffnung 30 und der Positionierfläche 36 positioniert ist. Mit anderen Worten wird in der Positionierstellung die Position des Wafers 22 in der Trägerbaugruppe 24 bzw. im Träger 26 festgelegt.

Wie aus den Figuren hervorgeht, ist die Auflage 32 im Bereich des Positionierteils 34 unterbrochen, sodass das Positionierteil 34 verkippt und den Wafer 22 seitlich kontaktieren kann.

In der gezeigten Ausführungsform umfasst der Kippmechanismus 40 eine Betätigungsfläche 42, welche an einer Oberseite eines Betätigungsteils 44 ausgebildet ist, das mit dem Positionierteil 34 mechanisch gekoppelt ist. Insofern handelt es sich bei dem Betätigungsteil 44 und dem Positionierteil 34 um zwei separate Bauteile, die miteinander verbunden sind. Die Verbindung kann dabei direkt oder wie in der gezeigten Ausführungsform mittels eines Distanzelements 46 erfolgen.

In einer alternativen Ausführungsform kann auch vorgesehen sein, dass ein einstückig ausgebildetes Bauteil vorgesehen ist, an dem sowohl die Positionierfläche 36 als auch die Betätigungsfläche 42 vorgesehen ist. Dieses einstückig ausgebildete Bauteil würde demnach die Funktion des Positionierteils 34, des Betätigungsteils 44 und des Distanzelements 46 gemeinsam aufweisen.

Der Kippmechanismus 40 umfasst zudem zumindest einen Lagerbock 48, der einen Schwenkpunkt für das Betätigungsteil 44 definiert. Der Lagerbock 48 weist eine Aufnahme 50 für einen Passstift 52 auf, der wiederum in eine Aufnahme des Betätigungsteils 44 eingreift, wodurch sich eine Schwenkachse S für das Betätigungsteil 44 ergibt. Das Betätigungsteil 44 kann um die Schwenkachse S verschwenkt bzw. verkippt werden.

In der gezeigten Ausführungsform umfasst der Kippmechanismus 40 zwei Lagerböcke 48, die in gleicher Weise ausgebildet sind.

Der wenigstens eine Lagerbock 48 ist mittels Schrauben 54 und optionalen Federn 56 mit dem Adapterring 28 mechanisch verbunden.

Zudem umfasst der Kippmechanismus 40 wenigstens eine Feder 58, beispielsweise eine Druckfeder. Die Feder 58 ist vorgesehen, um den Kippmechanismus 40 bzw. das Positionierteil 34 in die Positionierstellung vorzuspannen.

Hierzu stützt sich die Feder 58 in der gezeigten Ausführungsform am Träger 26 ab, um das zugeordnete Ende des Betätigungsteils 44 zu drücken, wodurch eine Schwenkbewegung um die Schwenkachse initiiert wird, die das Positionierteil 34 in die Positionierstellung beaufschlagt. In der gezeigten Ausführungsform ist die Feder 58 in einer Aufnahme 60 im Träger 26 zusammen mit einem optionalen Zylinderstift 62 aufgenommen.

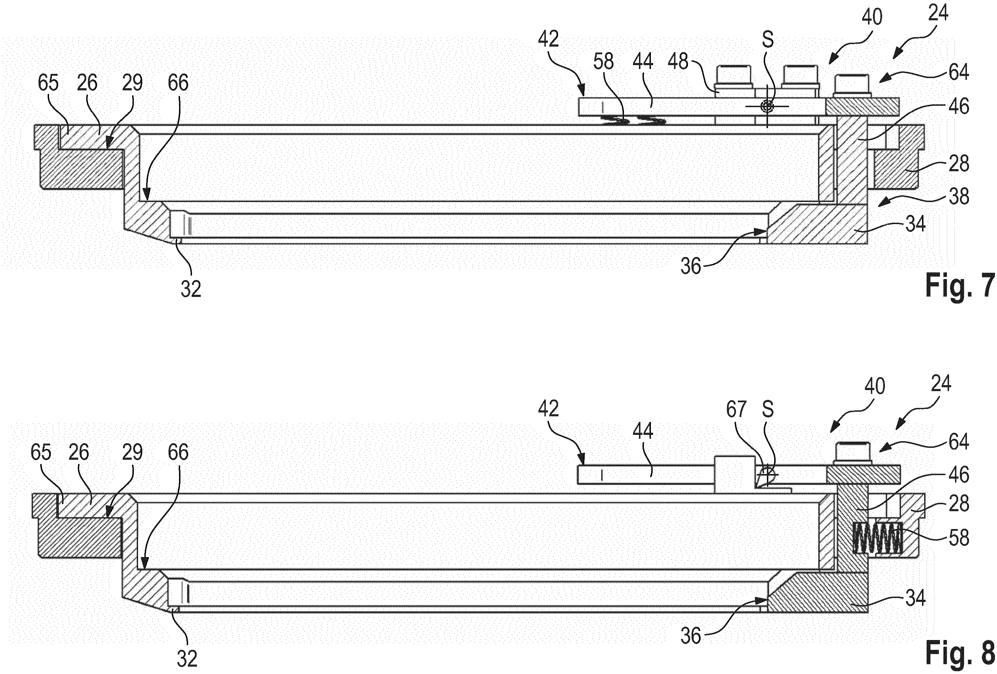

Aus der Figur 7 geht ferner hervor, dass der Träger 26 eine randseitige Aussparung 64 aufweist, durch die sich der Kippmechanismus 40 zumindest teilweise erstreckt, insbesondere das Distanzelement 46.

Die randseitige Aussparung 64 ist dabei unter anderem an einem Kragen 65 der Oberseite des Trägers 26 vorgesehen, sodass sich das Distanzelement 46 zwischen dem Träger 26 und dem Adapterring 28 hindurch erstrecken kann, wie aus Figur 7 deutlich wird. Hierdurch ist ein kompakter Kippmechanismus 40 realisiert, der es ermöglicht, dass mehrere Trägerbaugruppen 24 beim Mehrfachträger 20 nebeneinander angeordnet werden können, wodurch eine maximale Flächeneffizienz gewährleistet ist.

Grundsätzlich kann der Träger 26 über den Kragen 65 am Adapterring 28 anliegen, insbesondere der Auflagefläche 29.

Darüber hinaus ist hierdurch sichergestellt, dass der Kippmechanismus 40 in Draufsicht auf die Öffnung 30 im Träger 26 derart beabstandet zur Öffnung 30 vorgesehen ist, dass ein im Träger 26 aufgenommener Wafer 22 von zwei entgegengesetzten Seiten (vollständig) zugänglich ist, wie aus den Figuren deutlich wird.

Der Wafer 22 kann also von unten bestrahlt und gleichzeitig von oben gekühlt werden, indem eine Kühlvorrichtung in die Trägerbaugruppe 24 eingefahren wird.

Der Träger 26 kann dabei eine Anlagefläche 66 für die Kühlvorrichtung aufweisen, sodass die Kühlvorrichtung in definierter Weise in Bezug auf den im Träger 26 aufgenommenen Wafer 22 angeordnet wird. Hierdurch ist sichergestellt, dass die Kühlvorrichtung den Wafer 22, insbesondere dessen obere Seite, nicht direkt kontaktiert, sondern einen definierten Abstand hierzu einhält.

In Figur 8 ist eine alternative Ausführungsform gezeigt, die sich hinsichtlich des Kippmechanismus 40 von der in den Figuren 2 bis 7 gezeigten Ausführungsform unterscheidet. Konkret unterscheidet sich die in Figur 8 gezeigte Ausführungsform der Trägerbaugruppe 24 hinsichtlich der Positionierung der Feder 58 insofern, dass sich diese am Adapterring 28 abstützt und das Distanzelement 46 derart beaufschlagt, dass das Positionierteil 34 in die Positionierstellung vorgespannt ist.

Analog zur ersten Ausführungsform ist wiederum ein Betätigungsteil 44 vorgesehen, welches um die Schwenkachse S verschwenkt bzw. gekippt werden kann, die vorliegend durch zumindest eine Messerkante 67 definiert ist, mit der das Betätigungsteil 44 sich an einer Komponente der Trägerbaugruppe 24 abstützt, beispielsweise dem Adapterring 28.

Insofern ergibt sich die gleiche Handhabung hinsichtlich der in Figur 8 gezeigten Trägerbaugruppe 24 als für die in den Figuren 2 bis 7 gezeigte Trägerbaugruppe 24.

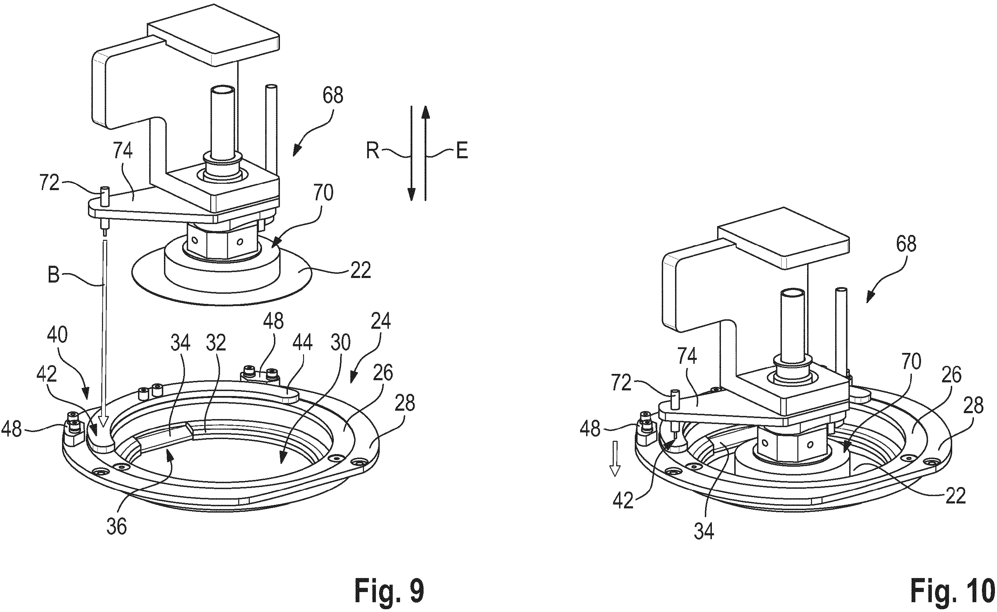

In den Figuren 9 und 10 ist ferner gezeigt, dass das System 10 eine Greifeinheit 68 umfasst, die beispielsweise als Endeffektor des Roboters 18 in dem in Figur 1 gezeigten System 10 vorgesehen sein kann.

Die Greifeinheit 68 umfasst neben einer Saugvorrichtung 70, mit dem der Wafer 22 gehalten werden kann, ein Auslöseelement 72, das seitlich beabstandet zur Saugvorrichtung 70 vorgesehen ist, insbesondere an einem Flansch 74.

Das Auslöseelement 72 ist federnd ausgebildet und zum Auslösen bzw. Betätigen des Kippmechanismus 40 vorgesehen, sodass das Auslöseelement 72 mit der Betätigungsfläche 42 zusammenwirkt, wenn der Wafer 22 in die Trägerbaugruppe 24 eingebracht wird, wie dies in Figur 9 und 10 gezeigt ist, oder aus der Trägerbaugruppe 24 entnommen wird.

Die Greifeinheit 68 wird dabei beim Beladen entlang einer Beladerichtung R parallel zu einer Betätigungsrichtung B des Kippmechanismus 40 verfahren, bis das Auslöseelement 72 die Betätigungsfläche 42 kontaktiert und gegen die Federvorspannung der Feder 58 verstellt, wodurch das Positionierteil 34 aus der Positionierstellung in die Freigabestellung überführt wird.

Die Greifeinheit 68 wird weiter in die Beladerichtung B verfahren, wobei das Auslöseelement 72 einfedert, wodurch sich ein zusätzlicher Hub für die Greifeinheit 68 ergibt, der sicherstellt, dass der Wafer 22 auf die zumindest eine Auflage 32 am Rand der Öffnung 30 aufgesetzt werden kann.

Anschließend wird die Saugvorrichtung 70 gelöst, indem der vorliegende Unterdruck abgebaut wird, sodass die Saugvorrichtung 70 den Wafer 22 loslässt. Dieser liegt nun nur noch auf der Auflage 32 auf.

Daraufhin wird die Greifeinheit 68 in seine Ausgangsstellung verfahren, wobei die Saugvorrichtung 70 den Wafer 22 nicht mehr kontaktiert. Die Komprimierung des federnden Auslöseelements 72 wird beim Zurückfahren in die Ausgangsstellung reduziert. Ab einem definierten Verfahrweg ist das Auslöseelement 72 nicht mehr komprimiert, sodass es sich beim weiteren Verfahren von der Betätigungsfläche 42 löst, sodass diese ebenfalls nicht mehr kontaktiert ist.

Spätestens dies hat zur Folge, dass der Kippmechanismus 40 in seine vorgespannte Stellung überführt wird, in der das Positionierteil 34 in seiner Positionierstellung ist und die Positionierfläche 36 den Wafer 22 seitlich positioniert, um so die Position des Wafers 22 im Träger 26 festzulegen.

In analoger Weise erfolgt die Betätigung bzw. das Auslösen des Kippmechanismus 40, wenn ein im Träger 26 eingesetzter Wafer 22 entnommen wird.

Die Greifeinheit 68 wird verfahren, um den Wafer 22 mittels der Saugvorrichtung 70 zu kontaktieren. Dabei kontaktiert zuvor das Auslöseelement 72 die Betätigungsfläche 42, wodurch das Positionierteil 34 aus der Positionierstellung in die Freigabestellung verkippt wird. Die Greifeinheit 68 wird weiter in Richtung des Wafers 22 verfahren, wodurch das Auslöseelement 72 einfedert, was der Greifeinheit 68 einen zusätzlichen Hubweg ermöglicht. Der zusätzliche Hubweg stellt sicher, dass die Saugvorrichtung 70 der Greifeinheit 68 den Wafer 22 in definierter Weise kontaktiert.

Anschließend wird ein Unterdruck an der Saugvorrichtung 70 aufgebaut, um den Wafer 22 zu halten. Die Greifeinheit 68 kann dann entlang der Entnahmerichtung E verfahren werden, die parallel zur Betätigungsrichtung B des Kippmechanismus 40 ist, wodurch der Wafer 22 aus dem Träger 26 entfernt wird.

Dabei wird zunächst das Auslöseelement 72 dekomprimiert. Anschließend wird der Kippmechanismus 40, also das Positionierteil 34, aufgrund der Feder 58 in seine Positionierstellung überführt. Dies ist jedoch erst dann der Fall, wenn sich die Greifeinheit 68 und der an dessen Saugvorrichtung 70 befindliche Wafer 22 außerhalb der Positionierfläche 36 befindet.

Die Greifeinheit 68 wird weiter in die Entnahmerichtung E verfahren, sodass der Wafer 22 entnommen ist.

Grundsätzlich kann der Kippmechanismus 40 so ausgestaltet sein, dass das Positionierteil 34 als Klemmteil 76 wirkt, sodass die Positionierfläche 36 eine Klemmfläche 78 ist, über die der Wafer 22 im Träger 26 klemmend gehalten ist.

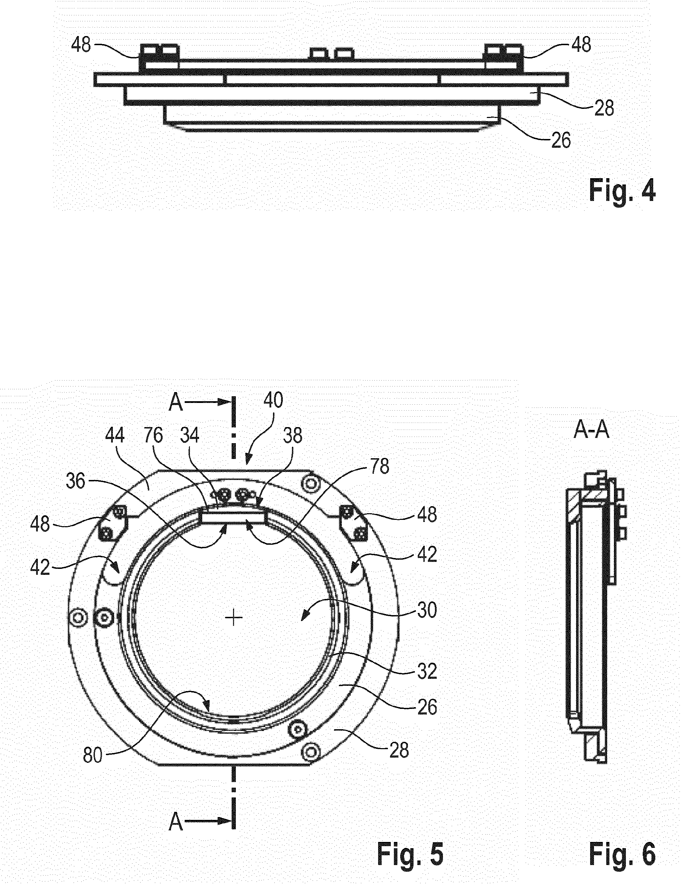

Zudem kann an einer Innenseite des Trägers 26, insbesondere gegenüberliegend zur Klemmfläche 78, eine Klemmkontur 80 ausgebildet sein, sodass der Wafer 22 zwischen der Klemmfläche 78 und der Klemmkontur 80 geklemmt ist, wie aus Figur 5 deutlich wird. Hierbei kann eine Drei-Punkt-Klemmung ausgebildet werden.

Der Kippmechanismus 40 kann im Allgemeinen symmetrisch ausgebildet sein, sodass zwei Lagerböcke 48, zwei Betätigungsflächen 42 sowie wenigstens zwei zugeordnete Federn 58 vorgesehen sind.

Das Betätigungsteil 44 kann bügel- oder boomerang-förmig ausgebildet sein, wobei die Betätigungsflächen 42 den freien Enden des Betätigungsteils 44 zugeordnet sind. Das Positionier- bzw. Klemmteil 34, 76 ist dagegen einer Mitte des Betätigungsteils 44 zugeordnet, wodurch sich wiederum die Symmetrie des Kippmechanismus 40 ergibt.

Wie vorstehend erläutert stellt die Trägerbaugruppe 24 aufgrund des Kippmechanismus 40 eine Möglichkeit dar, um beide Seiten des Wafers 22 gleichzeitig zu bearbeiten, ohne den Wafer 22 aus dem Träger 26 zu entnehmen. Zudem stellt der Kippmechanismus 40 eine platzsparende Möglichkeit für die Festlegung der Position des Wafers 22 im Träger 26, sodass mehrere Trägerbaugruppen 24 nebeneinander beim Mehrfachträger 20 vorgesehen sein können, wodurch die Effizienz erhöht ist, da eine hohe Anzahl an Wafern 22 gleichzeitig verarbeitet werden kann.

Der Kippmechanismus 40 stellt zudem sicher, dass eine Automatisierung möglich ist, da der Kippmechanismus 40 automatisiert betätigt werden kann, insbesondere automatisiert beim Einbringen oder Entnehmen des Wafers 22. Dies ist insofern möglich, da die Betätigungsrichtung B des Kippmechanismus 40 parallel zur Beladerichtung R bzw. Entnahmerichtung E ist. Trotz dieser Betätigungsrichtung B wird der Wafer 22 seitlich positioniert bzw. geklemmt, wodurch eine maximale Fläche des Wafers 22 bearbeitet werden kann, insbesondere im Vergleich zu Systemen, die mit Niederhaltern oder ähnlichem arbeiten.

## Patentansprüche

1. Trägerbaugruppe (24) zum spielfreien Positionieren eines Wafers (22), mit einem Träger (26) für den Wafer (22), einem Kippmechanismus (40) und einem Positionierteil (34), wobei der Träger (26) eine Öffnung (30) zur Aufnahme des Wafers (22) hat, wobei das Positionierteil (34) eine Positionierfläche (36) zum seitlichen Positionieren des Wafers (22) hat, und wobei der Kippmechanismus (40) eingerichtet ist, das Positionierteil (34) zwischen einer Freigabestellung und einer Positionierstellung zu verkippen, in der der Wafer (22) zwischen einem Rand der Öffnung (30) und der Positionierfläche (36) positioniert ist.

2. Trägerbaugruppe (24) nach Anspruch 1, **dadurch gekennzeichnet, dass** der Kippmechanismus (40) wenigstens eine Betätigungsfläche (42) aufweist, über die der Kippmechanismus (40) betätigbar ist, um das Positionierteil (34) zwischen der Positionierstellung und der Freigabestellung zu verkippen, wobei die Betätigungsfläche (42) in der Positionierstellung des Positionierteils (34) senkrecht zur Positionierfläche (36) ist.

3. Trägerbaugruppe (24) nach Anspruch 2, **dadurch gekennzeichnet, dass** der Kippmechanismus (40) ein Betätigungsteil (44) aufweist, das mit dem Positionierteil (34) mechanisch verbunden ist, wobei die Betätigungsfläche (42) am Betätigungsteil (44) ausgebildet ist.

4. Trägerbaugruppe (24) nach Anspruch 3, **dadurch gekennzeichnet, dass** der Kippmechanismus (40) wenigstens einen Lagerbock (48) aufweist, der einen Schwenkpunkt für das Betätigungsteil (44) definiert.

5. Trägerbaugruppe (24) nach einem der vorhergehenden Ansprüche, **dadurch gekennzeichnet, dass** der Träger (26) eine randseitige Aussparung (64) aufweist, durch die sich der Kippmechanismus (40) teilweise erstreckt.

6. Trägerbaugruppe (24) nach einem der vorhergehenden Ansprüche, **dadurch gekennzeichnet, dass** der Kippmechanismus (40) in Draufsicht auf die Öffnung (30) derart seitlich beabstandet zur Öffnung 30) vorgesehen ist, dass ein im Träger (26) aufgenommener Wafer (22) von zwei entgegengesetzten Seiten zugänglich ist.

7. Trägerbaugruppe (24) nach einem der vorhergehenden Ansprüche, **dadurch gekennzeichnet, dass** eine Feder (58) vorgesehen ist, die derart mit dem Kippmechanismus (40) zusammenwirkt, dass das Positionierteil (34) in die Positionierstellung vorgespannt ist.

8. Trägerbaugruppe (24) nach einem der vorhergehenden Ansprüche, **dadurch gekennzeichnet, dass** das Positionierteil (34) ein Klemmteil (76) ist, das eine Klemmfläche (78) zum seitlichen Klemmen des Wafers (22) hat, wobei der Kippmechanismus (40) eingerichtet ist, das Klemmteil (76) zwischen der Freigabestellung und einer Klemmstellung zu verkippen, in der der Wafer (22) zwischen einem Rand der Öffnung (30) und der Klemmfläche (78) geklemmt ist, insbesondere wobei an einer Innenseite des Trägers (26) eine Klemmkontur (80) ausgebildet ist, die der Klemmfläche (78) gegenüberliegt.

9. Trägerbaugruppe (24) nach einem der vorhergehenden Ansprüche, **dadurch gekennzeichnet, dass** am Rand der Öffnung (30) zumindest eine Auflage (32) für einen Rand des Wafers (22) vorgesehen ist, insbesondere wobei die zumindest eine Auflage (32) in einem Bereich unterbrochen ist, in dem das Positionierteil (34) angeordnet ist.

10. Trägerbaugruppe (24) nach einem der vorhergehenden Ansprüche, **dadurch gekennzeichnet, dass** ein Adapterring (28) vorgesehen ist, in dem der Träger (26) eingesetzt ist.

11. System (10) mit einer Greifeinheit (68) und einer Trägerbaugruppe (24) nach einem der vorhergehenden Ansprüche.

12. System (10) nach Anspruch 11, **dadurch gekennzeichnet, dass** die Greifeinheit (68) ein Auslöseelement (72) aufweist, das eingerichtet ist, den Kippmechanismus (40) zu betätigen, wobei die Greifeinheit (68) zumindest entlang einer Belade- und Entnahmerichtung (R, E) beweglich ist, wobei die Belade- und Entnahmerichtung (R, E) parallel zu einer Betätigungsrichtung (B) des Kippmechanismus 40 der Trägerbaugruppe (24) ist, und wobei das Auslöseelement (72) beim Beladen des Trägers (26) mit dem Wafer (22) und beim Entnehmen des Wafers (22) aus dem Träger (26) den Kippmechanismus (40) betätigt, um das Positionierteil (34) in die Freigabestellung zu verkippen.

13. System (10) nach Anspruch 11 oder 12, **dadurch gekennzeichnet, dass** das Auslöseelement (72) federnd ausgebildet ist.

14. Verfahren zum spielfreien Positionieren eines Wafers (22) in einem Träger (26) für den Wafer (22), mit den Schritten:
- Bereitstellen einer Trägerbaugruppe (24) mit dem Träger (26) für den Wafer (22),
- Betätigen eines Kippmechanismus (40) der Trägerbaugruppe (24), um ein Positionierteil (34) mit einer Positionierfläche (36) zum seitlichen Positionieren des Wafers (22) im Träger (26) aus einer Positionierstellung in eine Freigabestellung zu verkippen,
- Einbringen des Wafers (22) in den Träger (26), und
- Freigeben des Kippmechanismus (40) der Trägerbaugruppe (24), sodass sich das Positionierteil (34) aus der Freigabestellung in die Positionierstellung zurückstellt und die Positionierfläche (36) seitlich am Wafer (22) anliegt, um diesen im Träger (26) zu positionieren.

15. Verfahren zum Entnehmen eines Wafers (22) aus einem Träger (26) für den Wafer (22), mit den Schritten:
- Bereitstellen einer Trägerbaugruppe (24) mit dem Träger (26) für den Wafer (22), wobei der Wafer (22) in dem Träger (26) positioniert ist,
- Betätigen eines Kippmechanismus (40) der Trägerbaugruppe (24), um ein Positionierteil (34) mit einer Positionierfläche (36) zum seitlichen Positionieren des Wafers (22) im Träger (26) aus einer Positionierstellung, in der die Positionierfläche (36) seitlich am Wafer (22) anliegt, in eine Freigabestellung zu verkippen,
- Entnehmen des Wafers (22) aus dem Träger (26), und
- Freigeben des Kippmechanismus (40) der Trägerbaugruppe (24), sodass sich das Positionierteil (34) aus der Freigabestellung in die Positionierstellung zurückstellt.

## Geänderte Patentansprüche

### Geänderte Patentansprüche gemäss Regel 137(2) EPÜ.

1. Trägerbaugruppe (24) zum spielfreien Positionieren eines Wafers (22), mit einem Träger (26) für den Wafer (22), einem Kippmechanismus (40) und einem Positionierteil (34), wobei der Träger (26) eine Öffnung (30) zur Aufnahme des Wafers (22) hat, wobei das Positionierteil (34) eine Positionierfläche (36) zum seitlichen Positionieren des Wafers (22) hat, und wobei der Kippmechanismus (40) eingerichtet ist, das Positionierteil (34) zwischen einer Freigabestellung und einer Positionierstellung zu verkippen, in der der Wafer (22) zwischen einem Rand der Öffnung (30) und der Positionierfläche (36) positioniert ist, **dadurch gekennzeichnet, dass** am Rand der Öffnung (30) zumindest eine Auflage (32) für einen Rand des Wafers (22) vorgesehen ist.

2. Trägerbaugruppe (24) nach Anspruch 1, **dadurch gekennzeichnet, dass** der Kippmechanismus (40) wenigstens eine Betätigungsfläche (42) aufweist, über die der Kippmechanismus (40) betätigbar ist, um das Positionierteil (34) zwischen der Positionierstellung und der Freigabestellung zu verkippen, wobei die Betätigungsfläche (42) in der Positionierstellung des Positionierteils (34) senkrecht zur Positionierfläche (36) ist.

3. Trägerbaugruppe (24) nach Anspruch 2, **dadurch gekennzeichnet, dass** der Kippmechanismus (40) ein Betätigungsteil (44) aufweist, das mit dem Positionierteil (34) mechanisch verbunden ist, wobei die Betätigungsfläche (42) am Betätigungsteil (44) ausgebildet ist.

4. Trägerbaugruppe (24) nach Anspruch 3, **dadurch gekennzeichnet, dass** der Kippmechanismus (40) wenigstens einen Lagerbock (48) aufweist, der einen Schwenkpunkt für das Betätigungsteil (44) definiert.

5. Trägerbaugruppe (24) nach einem der vorhergehenden Ansprüche, **dadurch gekennzeichnet, dass** der Träger (26) eine randseitige Aussparung (64) aufweist, durch die sich der Kippmechanismus (40) teilweise erstreckt.

6. Trägerbaugruppe (24) nach einem der vorhergehenden Ansprüche, **dadurch gekennzeichnet, dass** der Kippmechanismus (40) in Draufsicht auf die Öffnung (30) derart seitlich beabstandet zur Öffnung 30) vorgesehen ist, dass ein im Träger (26) aufgenommener Wafer (22) von zwei entgegengesetzten Seiten zugänglich ist.

7. Trägerbaugruppe (24) nach einem der vorhergehenden Ansprüche, **dadurch gekennzeichnet, dass** eine Feder (58) vorgesehen ist, die derart mit dem Kippmechanismus (40) zusammenwirkt, dass das Positionierteil (34) in die Positionierstellung vorgespannt ist.

8. Trägerbaugruppe (24) nach einem der vorhergehenden Ansprüche, **dadurch gekennzeichnet, dass** das Positionierteil (34) ein Klemmteil (76) ist, das eine Klemmfläche (78) zum seitlichen Klemmen des Wafers (22) hat, wobei der Kippmechanismus (40) eingerichtet ist, das Klemmteil (76) zwischen der Freigabestellung und einer Klemmstellung zu verkippen, in der der Wafer (22) zwischen einem Rand der Öffnung (30) und der Klemmfläche (78) geklemmt ist, insbesondere wobei an einer Innenseite des Trägers (26) eine Klemmkontur (80) ausgebildet ist, die der Klemmfläche (78) gegenüberliegt.

9. Trägerbaugruppe (24) nach einem der vorhergehenden Ansprüche, **dadurch gekennzeichnet, dass** die zumindest eine Auflage (32) in einem Bereich unterbrochen ist, in dem das Positionierteil (34) angeordnet ist.

10. Trägerbaugruppe (24) nach einem der vorhergehenden Ansprüche, **dadurch gekennzeichnet, dass** ein Adapterring (28) vorgesehen ist, in dem der Träger (26) eingesetzt ist.

11. System (10) mit einer Greifeinheit (68) und einer Trägerbaugruppe (24) nach einem der vorhergehenden Ansprüche.

12. System (10) nach Anspruch 11, **dadurch gekennzeichnet, dass** die Greifeinheit (68) ein Auslöseelement (72) aufweist, das eingerichtet ist, den Kippmechanismus (40) zu betätigen, wobei die Greifeinheit (68) zumindest entlang einer Belade- und Entnahmerichtung (R, E) beweglich ist, wobei die Belade- und Entnahmerichtung (R, E) parallel zu einer Betätigungsrichtung (B) des Kippmechanismus 40 der Trägerbaugruppe (24) ist, und wobei das Auslöseelement (72) beim Beladen des Trägers (26) mit dem Wafer (22) und beim Entnehmen des Wafers (22) aus dem Träger (26) den Kippmechanismus (40) betätigt, um das Positionierteil (34) in die Freigabestellung zu verkippen.

13. System (10) nach Anspruch 11 oder 12, **dadurch gekennzeichnet, dass** das Auslöseelement (72) federnd ausgebildet ist.

14. Verfahren zum spielfreien Positionieren eines Wafers (22) in einem Träger (26) für den Wafer (22), mit den Schritten:
- Bereitstellen einer Trägerbaugruppe (24) mit dem Träger (26) für den Wafer (22), wobei der Träger (26) eine Öffnung (30) zur Aufnahme des Wafers (22) hat, wobei am Rand der Öffnung (30) zumindest eine Auflage (32) für einen Rand des Wafers (22) vorgesehen ist,
- Betätigen eines Kippmechanismus (40) der Trägerbaugruppe (24), um ein Positionierteil (34) mit einer Positionierfläche (36) zum seitlichen Positionieren des Wafers (22) im Träger (26) aus einer Positionierstellung in eine Freigabestellung zu verkippen,
- Einbringen des Wafers (22) in den Träger (26), und
- Freigeben des Kippmechanismus (40) der Trägerbaugruppe (24), sodass sich das Positionierteil (34) aus der Freigabestellung in die Positionierstellung zurückstellt und die Positionierfläche (36) seitlich am Wafer (22) anliegt, um diesen im Träger (26) zu positionieren.

15. Verfahren zum Entnehmen eines Wafers (22) aus einem Träger (26) für den Wafer (22), mit den Schritten:
- Bereitstellen einer Trägerbaugruppe (24) mit dem Träger (26) für den Wafer (22), wobei der Träger (26) eine Öffnung (30) zur Aufnahme des Wafers (22) hat, wobei am Rand der Öffnung (30) zumindest eine Auflage (32) für einen Rand des Wafers (22) vorgesehen ist, wobei der Wafer (22) in dem Träger (26) positioniert ist,
- Betätigen eines Kippmechanismus (40) der Trägerbaugruppe (24), um ein Positionierteil (34) mit einer Positionierfläche (36) zum seitlichen Positionieren des Wafers (22) im Träger (26) aus einer Positionierstellung, in der die Positionierfläche (36) seitlich am Wafer (22) anliegt, in eine Freigabestellung zu verkippen,
- Entnehmen des Wafers (22) aus dem Träger (26), und
- Freigeben des Kippmechanismus (40) der Trägerbaugruppe (24), sodass sich das Positionierteil (34) aus der Freigabestellung in die Positionierstellung zurückstellt.
